Europäisches Patentamt

European Patent Office

Office européen des brevets

(19)

(11) **EP 0 714 163 A1**

(12) **EUROPEAN PATENT APPLICATION**

(43) Date of publication:
29.05.1996 Bulletin 1996/22

(51) Int. Cl.⁶: $H03D\ 7/14$

(21) Application number: 95308303.7

(22) Date of filing: 21.11.1995

(84) Designated Contracting States:
AT BE CH DE DK ES FR GB GR IE IT LI LU MC NL
PT SE

(30) Priority: 23.11.1994 US 344375

(71) Applicant: ANALOG DEVICES, INCORPORATED
Norwood, MA 02062-9106 (US)

(72) Inventor: Gilbert, Barrie
Beaverton, Oregon 97006-1994 (US)

(74) Representative: Allen, William Guy Fairfax
J.A. KEMP & CO.
14 South Square
Gray's Inn
London WC1R 5LX (GB)

(54) **Low supply voltage mixer**

(57) A mixer (24) includes a differential input section (31) and two diverting transistors (Q11,Q12). The differential input section (31) includes two differential pairs of transistors (Q7,Q8;Q9Q10), each having a separate current source (44,46) coupled thereto for supplying current (I1,I2) to the respective differential pair. The bases of the two differential pairs are combined to form a first differential input (32,34) for receiving a first differential input signal (VRF) and the collectors of the differential pairs are combined to form a pair of differential outputs (40,42) for producing a mixed differential output signal. One diverting transistor (Q11 or Q12) is coupled between a supply voltage ($V_{pos}$) and a respective current source (44 or 46) to divert the current away from the associated differential pair responsive to a second, overlapping differential input signal applied to the base of the diverting transistor (Q11 or Q12). The diversion effectively mixes the first and second differential input signals to produce the mixed differential output signal.

Fig.2

## Description

### BACKGROUND OF THE INVENTION

This invention relates generally to analog signal processing and more particularly to an analog mixer.

Ever since the invention of the super heterodyne concept by Armstrong in 1918, mixers have been of importance in determining the overall performance of modern radio receivers, virtually all of which require at least one mixer. The name "mixer" was badly chosen from the start, because this component doesn't mix signals in the way that, say, an audio recording console does, i.e., by summing all inputs linearly, rather, it multiplies them, frequency-pair by frequency-pair, often producing very complex products in the process. From an input spectrum containing perhaps hundreds of competing signals at the receiver's antenna, only one of these frequency products should be passed by the selectivity-producing filters (at the IF) placed after the mixer. This one wanted signal is thereafter amplified, usually by a variable amount of gain-- depending upon the received signal strength-- and the modulation information finally recovered by an appropriate detector.

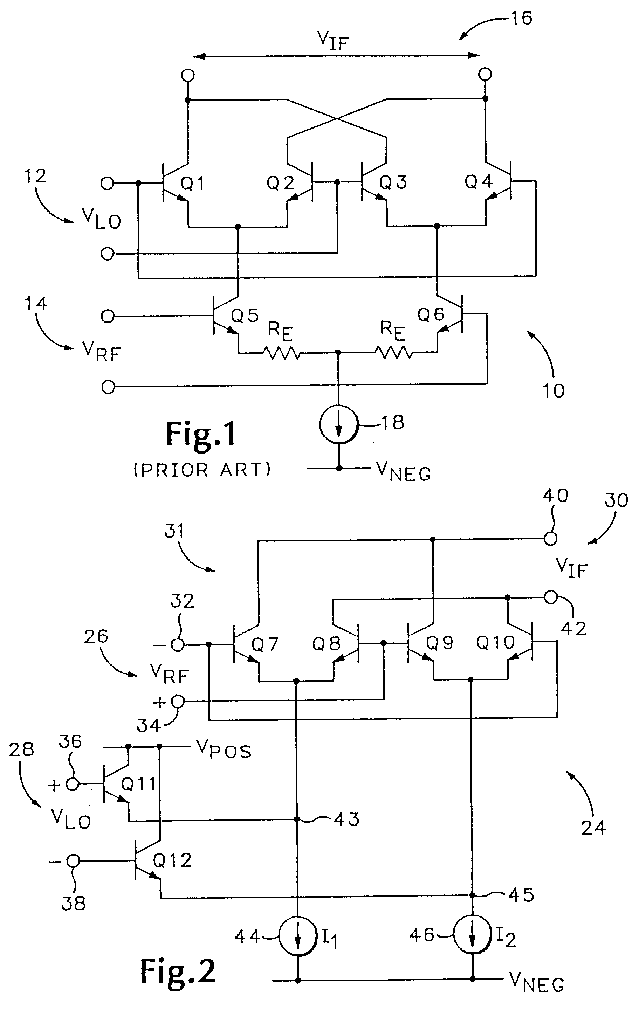

An example of a classic active mixer is shown in FIG. 1. The mixer 10 is commonly known as the "Gilbert Mixer" after the inventor of the present application. In fact, a prior art search at the time of the invention thereof produced a reference, U.S. Patent No. 3,241,078 issued to Jones, which showed essentially the same circuit, although it was described as a "synchronous detector," and did not seem to envision its utility in mixer applications.

The operation of the mixer 10 is as follows. In the absence of any voltage difference between the base of Q5 and Q6, the collector currents of these two transistors are essentially equal. Thus, a voltage applied to the LO port 12 results in no change of output current. Should a small DC offset voltage be present at the RF port (due, say, to a mismatch in the emitter areas of Q1 and Q2), this will only result to a small feed through of the LO signal $V_{LO}$ to the IF port 16, which will be blocked by a first IF filter (not shown). Conversely, if an RF signal $V_{RF}$ is applied to the RF port 14, but no voltage difference is applied to the LO port 12, the output currents will again be balanced. A small offset voltage (due now to emitter mismatch in Q1-Q4) may cause some RF signal feed through to the IF port; as before, this will be rejected by the IF filter. Thus it is only then when a signal supplied to both the LO port 12 and the RF port 14 that a signal appears at the IF port 16.

In order to minimize power consumption, many circuits are designed using a low voltage supply. Unfortunately, the mixer 10 of FIG. 1 has difficulty operating at such low voltages. This can be seen by examining mixer 10. Voltage drops due to current source 18, an emitter degenerative resistor $R_E$, and transistors Q1 and Q5 consume all or most of the supply voltage in these low voltage applications. These cumulative voltage drops significantly limit the signal range of the output signal $V_{1F}$

Accordingly, a need remains for a mixer for low voltage applications.

### SUMMARY OF THE INVENTION

It is, therefore, an object of the invention to provide a mixer for low voltage applications.

The mixer according to the invention includes a differential input section comprised of a first and a second differential pair, each differential pair having an associated current source for supplying current thereto. The differential input section includes a pair of differential outputs for producing a mixed differential output signal and a first pair of differential inputs for receiving a first differential input signal. The voltage drop across the differential input section is significantly less than that produced across the prior art Gilbert Mixer.

The mixer according to the invention further includes two transistors for diverting current away from the differential pairs of transistors responsive to a second differential input signa applied to the bases of the transistors, which is mixed with the first differential input signal. The two transistors are effectively in parallel with an associated differential pair of transistors and, therefore, do not consume any additional supply voltage. Thus, the mixer according to the invention is capable of operating at lower supply voltage applications than the prior art mixer.

In operation, the voltage swing of the second differential input signal applied to the two transistors is greater than the signal range of the first differential input signal. The range of the first input signal is greater in order to divert substantially all of the current supplied by the current source away from the differential pair of transistors to the associated transistor.

In another aspect of the invention, the noise performance of the prior are Gilbert Mixer is improved by using a so-called multi-tanh doublet in place of the differential pair (Q5 and Q6) and the associated emitter degenerative resistors ($R_E$). The multi-tanh doublet includes two pairs of differential pairs arranged to be offset along the voltage axis. Because each pair has a hyperbolic tangent (tanh) response to the input, the multiple-pair circuit is called a "multi-tanh." The offsets are achieved, in the preferred embodiment, by ratioing the emitter areas of the transistors. The multi-tanh doublet results in an overall transconductance ($g_M$) which is much flatter than the simple differential pair in the prior art, which results in an improvement in linearity.

The foregoing and other objects, features and advantages of the invention will become more readily apparent from the following detailed description of a preferred embodiment of the invention which proceeds with reference to the accompanying drawings.

### BRIEF DESCRIPTION OF THE DRAWINGS

FIG. 1 is a schematic of a prior art mixer cell.

FIG. 2 is a schematic of a mixer cell for low voltage applications according to the invention.

FIG. 3 is a schematic of the current sources of the mixer of FIG. 2.

FIG. 4 is a plot of the two differential input signals applied to the mixer of FIG. 2.

FIG. 5 is a schematic of a mixer according to a second aspect of the invention which uses a multi-tanh doublet.

FIG. 6 is a plot of the transconductance ($g_M$) of the multi-tanh doublet of the mixer of FIG. 5.

DETAILED DESCRIPTION

Referring to FIG. 2, a mixer 24 according to the invention is shown. As in the prior art mixer, the mixer 24 includes an RF port 26, an LO port 28 and an IF port 30. The mixer 24 further includes a differential input section 31 comprised of transistors Q7-Q10. Transistors Q7-Q10 form two differential pairs of transistors. The first differential pair of transistors includes transistors Q7 and Q8, which are coupled to a current source 44 for supplying a first current $I_1$ thereto. The second differential pair of transistors includes transistors Q9-Q10, which are coupled to a second current source 46 for supplying a second current $I_2$ to the second differential pair of transistors.

The RF port 26 includes two differential inputs 32 and 34. The differential input 34 is coupled to the bases of transistors Q8 and Q9. The second differential input 32 is coupled to the bases of transistors Q7 and Q10. A first input signal $V_{RF}$ is applied across the two differential inputs 32 and 34.

The IF port 30 includes two outputs 40 and 42. The first output 40 is coupled to the collectors of transistors Q7 and Q9 while the second output 42 is coupled to the sources of transistors Q8 and Q10. The differential output signal $V_{IF}$ is produced across the pair of differential outputs 40 and 42 responsive to the signals applied to the RF and LO ports, as described further below.

The mixer 24 also includes two diverting transistors Q11 and Q12. Transistor Q11 is coupled between a positive supply voltage $V_{POS}$ and an node 43 formed between the first differential pair of transistors (Q7,Q8) and the associated current source 44. Similarly, the second transistor Q12 is coupled between the supply voltage $V_{POS}$ and a node 45 formed between the second differential pair of transistors (Q9,Q10) and the associated current source 46. The base of transistor Q11 forms a first differential input 36 and the base of transistor Q12 forms a second differential input 38. The two differential inputs 36 and 38 form the LO port 28 for receiving a second differential input signal $V_{LO}$.

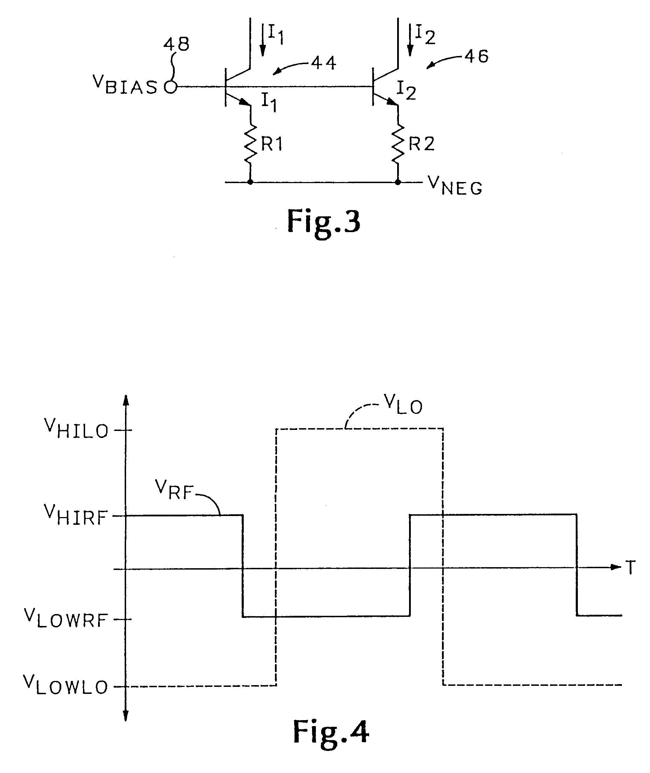

An exemplary schematic of the current sources 44 and 46 is shown in FIG 3. The current sources 44 and 46 are single transistors having optional emitter degeneration resistors coupled thereto. The transistors $QI_1$ and $QI_2$ are biased by a bias voltage $V_{BIAS}$ at an input terminal 48 coupled to the bases thereof. Although other current sources can be used, the implementation shown in FIG. 3 results in minimum voltage drop thereacross.

In operation, a positive signal on input 36 causes substantially all of the currents $I_1$ to be diverted from the first differential pair of transistors (Q7,Q8) to the first transistor Q11. This effectively shuts down the first differential pair of transistors. Similarly, when a positive voltage appears on input 38, substantially all of the current $I_2$ is diverted away from the second differential pair of transistors (Q9, Q10) to the second transistor Q12.

In order for the transistors Q11 and Q12 to divert the currents $I_1$ and $I_2$ away from their respective differential pairs of transistors, the input signals $V_{RF}$ and $V_{LO}$ must have an overlapping relationship, as shown in FIG. 4. This overlapping relationship requires that the most positive voltage of $V_{LO}$, shown as $V_{HILO}$, in FIG. 4, must be greater than the most positive voltage of signal $V_{RF}$, i.e., $V_{HIRF}$. This is to ensure that substantially all of the current is diverted to the transistors Q11 and Q12. In the preferred embodiment, the relationship of $V_{HILO}$ to $V_{HIRF}$ is given by the following equation:

$$V_{HILO} > V_{HIRF} + 4V_T$$

$V_T$ is equal to the threshold voltage of a bipolar junction transistor (BJT), which is approximately 26mV.

At the opposite extreme, the most negative voltage of signal $V_{LO}$ ($V_{LOWLO}$) must be more negative than the most negative voltage of $V_{RF}$ ($V_{LOWRF}$) the relationship between these two extremes is given by a similar equation to that above:

$$V_{LOWLO} < V_{LOWRF} - 4V_T$$

By satisfying these equations, the mixer produces less than one percent error. Thus, it can be seen from FIG. 4 that the input signal $V_{LO}$ "overlaps" input signal $V_{RF}$.

The mixer 24 according to the invention operates at a substantially lower supply voltage than the prior art. The mixer 24 can operate at approximately 1 volt of supply voltage.

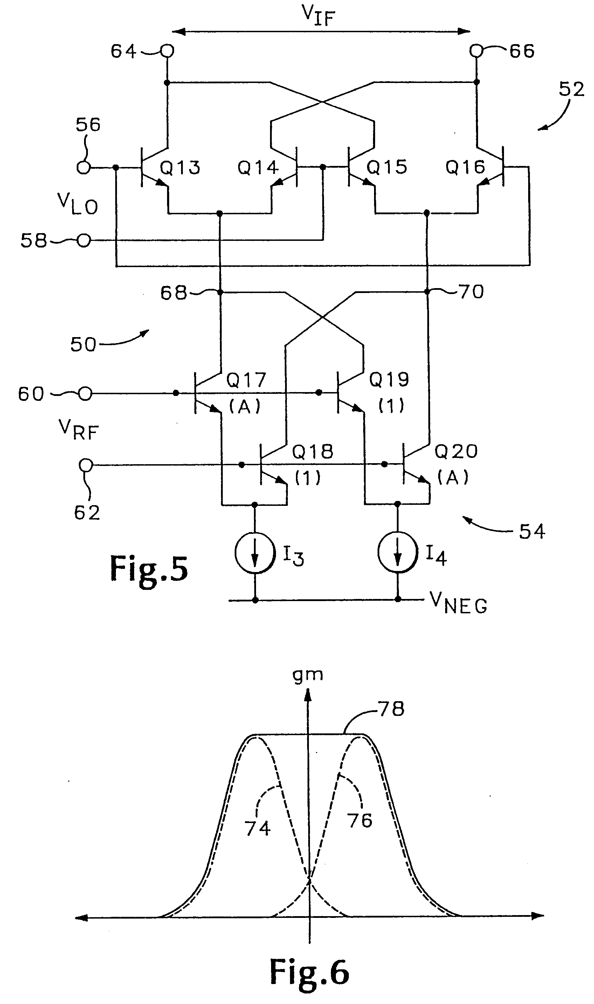

Referring now to FIG. 5, a mixer 50 according to a second aspect of the invention is shown. The mixer 50 includes an active mixer portion 52, which is similar to that used in the prior art Gilbert Mixer of FIG. 1. The active mixer portion 52, however, does not include emitter degeneration resistors as in the prior art. The mixer 50 further includes, according to the invention, a so-called multi-tanh doublet comprised of transistors Q17-Q20. The multi-tanh doublet 54 is used in place of the simple differential pair of the prior art mixer. The multi-tanh doublet 54 has s linear transconductance ($g_M$) resulting in improved noise performance of the mixer 50, as described further below.

The multi-tanh doublet 54 is comprised of two pairs of differential pairs of transistors with their inputs and outputs in parallel. The junction area of one emitter in each pair is arranged to be A times larger than the opposite emitter. In a monolithic embodiment, the common bases and collectors of Q17-Q19 and Q18-Q20, respectively, allow this to be done in a very compact manner using just two pairs of emitters instead of one. The effect of the emitter area ratio is usually shown to lift the peak of each transconductance ($g_M$) by an equivalent offset voltage $V_{OS}$ given by the following:

$$V_{OS} = +-V_T \times Ln(A)$$

For A=4, the Q17-Q18 pair shift approximately 36mV (at T=300K) in one direction while the Q19-Q20 pair shift in the other, with the result that the two $g_M$ segments, each having a sech$^2$ relationship, add in such a way as to result in an overall $g_M$ which is much flatter than the simple differential pair used in the prior art, with a resulting improvement in linearity. FIG.6 shows the individual $g_M$ plots 74 and 76 to the two pairs and the combined sum 78. As is apparent from FIG. 6, the combined sum has a substantially linear transconductance region. This improved linearity results in a substantial increase of the dynamic range of the mixer as well as the relative noise power.

The multi-tanh principal can be extended to include N differential pairs of transistors, resulting in a so-called multi-tanh couplet. Although this basic multi-tanh principal has been discussed by the inventor of the present application for many years, the principal has not been adopted or disclosed in any mixer application.

Having described and illustrated the principles of the invention in a preferred embodiment thereof, it should be apparent that the invention can be modified in arrangement and detail without departing from such principles. I claim all modifications and variation coming within the spirit and scope of the following claims.

## Claims

1. A mixer comprising:

a differential input section having a first pair of differential inputs for receiving a first differential input signal, a pair of differential outputs for producing a mixed differential output signal, a first differential pair of transistors and a second differential pair of transistors;

a first transistor having a control terminal and being coupled to the differential input section for diverting a first current from the first differential pair of transistors to the first transistor responsive to a signal applied to the control terminal of the first transistor; and

a second transistor having a control terminal and coupled to the differential input section for diverting a second current from the second differential pair of transistors to the second transistor responsive to a signal applied to the control terminal of the second transistor;

wherein the control terminals of the first and second transistors form a second pair of differential inputs for receiving a second differential input signal for mixing with the first differential input signal to produce the differential output signal by the mixer.

2. A mixer according to claim 1 further comprising:

a first current source coupled to the first differential pair of transistors for supplying the first current thereto; and

a second current source coupled to the second differential pair of transistors for supplying the second current thereto; wherein

the first differential pair of transistors has a pair of differential inputs coupled to the first pair of differential inputs and a pair of differential outputs coupled to the pair of differential outputs of the mixer; and

the second differential pair of transistors has a pair of differential inputs coupled to the first pair of differential inputs, the differential inputs of the second differential pair of transistors being coupled in an opposite polarity to that of the first differential pair of transistors, and a pair of differential outputs coupled to the pair of mixer differential outputs.

3. A mixer according to claim 2 wherein the first transistor is coupled to the first current source for diverting the first current from the first differential pair of transistors to the first transistor.

4. A mixer according to claim 2 or 3 wherein the second transistor is coupled to the second current source for diverting the second current from the second differential pair of transistors to the second transistor.

5. A mixer according to any one of claim 1 to 4 wherein the first and second transistors are bipolar junction transistors (BJTs) having a base, a collector, and an emitter, the bases of the transistors forming the respective control terminals of the first and second transistors.

6. A mixer according to claim 5 when dependent on claim 2, wherein the emitter of the first transistor is coupled to the first current source for diverting the first current from the first differential pair of transistors to the first transistor.

7. A mixer according to claim 5 or 6 wherein the collector of the first transistor is coupled to a first supply terminal for receiving a first supply voltage.

8. The mixer according to any one of the preceding claims wherein the first differential input signal and the second differential input signal have overlapping input signal ranges.

9. The mixer according to any one of the preceding claims wherein the first differential input signal and the second differential input signal are related by the following expressions:

$$V_{HILO} > V_{HIRF} + 4V_T; \text{ and}$$

$$V_{LOWLO} < V_{LOWRF} - 4V_T$$

where $V_T$ is equal to the threshold voltage of a bipolar junction transistor (BJT),
$V_{HILO}$ is equal to the most positive voltage of the second differential input signal,
$V_{HIRF}$ is equal to the most positive voltage of the first differential input signal,
$V_{LOWLO}$ is equal to the most negative voltage of the second differential input signal,
and $V_{LOWRF}$ is equal to the most negative voltage of the first differential input signal.

**Fig.1**

(PRIOR ART)

**Fig.2**

Fig.3

Fig.4

**Fig.5**

**Fig.6**

8

European Patent
Office

**EUROPEAN SEARCH REPORT**

Application Number

EP 95 30 8303

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | DE-A-42 05 486 (LICENTIA PATENT-VERWALTUNGS-GMBH) | 1-4 | H03D7/14 |
| A | * column 1, line 15 - line 18; figures 1,3 * <br> * column 1, line 59 - column 2, line 26 * | 6,7 | |
| X | US-A-5 151 625 (ZARABADI ET AL.) | 1-4 | |
| A | * abstract; figure 1 * | 6,7 | |
| X | EP-A-0 073 929 (SIEMENS AKTIENGESELLSCHAFT) | 1-4 | |
| A | * page 4, line 24 - page 6, line 33; figures 2,5 * <br> * page 8, line 36 - page 9, line 11 * | 6,7 | |
| X,P | GB-A-2 284 116 (NEC CORPORATION) | 1-4 | |
| A | * the whole document * | 6,7 | |
| A | ELECTRONICS LETTERS, <br> vol. 13, no. 17, 18 August 1977 STEVENAGE, U.K., <br> pages 506-508, <br> BARRIE GILBERT: 'Circuits for the precise synthesis of the sine function' | | |

TECHNICAL FIELDS
SEARCHED     (Int.Cl.6)

H03D

The present search report has been drawn up for all claims

| Place of search | Date of completion of the search | Examiner |
|---|---|---|
| THE HAGUE | 22 February 1996 | Peeters, M |